(19) Europäisches Patentamt
European Patent Office
Office européen des brevets

(11) **EP 3 961 810 A1**

(12) **EUROPEAN PATENT APPLICATION**

(43) Date of publication:
**02.03.2022 Bulletin 2022/09**

(21) Application number: **21192548.2**

(22) Date of filing: **23.08.2021**

(51) International Patent Classification (IPC):
*H01Q 1/36* (2006.01)    *H01Q 1/38* (2006.01)
*H01Q 13/20* (2006.01)    *H01Q 7/00* (2006.01)
*H01Q 9/04* (2006.01)    *H01Q 9/27* (2006.01)
*H01Q 9/28* (2006.01)

(52) Cooperative Patent Classification (CPC):
**H01Q 1/36;** H01Q 1/38; H01Q 7/00; H01Q 9/0407;
H01Q 9/27; H01Q 9/285; H01Q 13/206

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.08.2020 JP 2020145414**

(71) Applicant: **Nitto Denko Corporation
Ibaraki-shi
Osaka 567-8680 (JP)**

(72) Inventors:
• **Inoue, Masami**
**Ibaraki-shi, Osaka (JP)**
• **Yamazaki, Hiroshi**
**Ibaraki-shi, Osaka (JP)**

(74) Representative: **Hoffmann Eitle
Patent- und Rechtsanwälte PartmbB
Arabellastraße 30
81925 München (DE)**

(54) **WIRED CIRCUIT BOARD**

(57) A wired circuit board 1 includes a base insulating layer 2, and a circuit 3 disposed on a one-side surface in the thickness direction of the base insulating layer 2. The circuit 3 includes a transmitting and receiving circuit 5 and a component mounting circuit 6. The transmitting and receiving circuit 5 includes a first wire 7. The first wire 7 includes a first aspect ratio R1. The component mounting circuit 6 includes a second wire 8 electrically connected to the first wire 7. The second wire 8 has a second aspect ratio R2 lower than the first aspect ratio R1.

EP 3 961 810 A1

**Description**

TECHNICAL FIELD

The present invention relates to a wired circuit board.

BACKGROUND ART

The wired circuit board includes an insulating layer, and a circuit disposed on the one-side surface in the thickness direction of the insulating layer.

For example, there is a proposed flat coil element including an insulating base film and a conductive pattern disposed on the principal surface of the insulating base film (for example, see Patent Document 1 cited below). In Patent Document 1, the aspect ratio of the conductive pattern is set to 0.5 or more and 5 or less, thereby downsizing the flat coil element. The conductive pattern has a spiral portion and an external drawing portion connected to the outermost end of the spiral portion.

Citation List

Patent Document

Patent Document 1: International Patent Application Publication No. WO2016/147993

SUMMARY OF THE INVENTION

PROBLEM TO BE SOLVED BY THE INVENTION

However, the region including the external drawing portion is sometimes bent. When the external drawing portion has the same aspect ratio as that of the spiral portion, there is a disadvantage that the above-described region has low crease performance. The aspect ratio is the ratio of the thickness to the width.

The present invention provides a wired circuit board including a component mounting circuit portion having excellent crease performance, and a transmitting and receiving circuit having excellent transmitting and receiving properties and a small size.

MEANS FOR SOLVING THE PROBLEM

The present invention [1] includes a wired circuit board comprising: an insulating layer, and a circuit disposed on a one-side surface in a thickness direction of the insulating layer, wherein the circuit includes a transmitting and receiving circuit, and a component mounting circuit electrically connected to the transmitting and receiving circuit, the transmitting and receiving circuit includes a first wire, the first wire has a first aspect ratio that is a ratio of a thickness to a width, the component mounting circuit includes a second wire electrically connected to the first wire, and the second wire has a second aspect ratio lower than the first aspect ratio.

In the wired circuit board, the second wire has the second aspect ratio lower than the first aspect ratio. Thus, the component mounting circuit portion has excellent crease performance. Meanwhile, the transmitting and receiving circuit portion has excellent transmitting and receiving properties and a small size.

The present invention [2] includes the wired circuit board described in [1] above, wherein an upper limit of a ratio of the second aspect ratio to the first aspect ratio is 0.9.

In the wired circuit board, the component mounting circuit portion has even more excellent crease performance, and a transmitting and receiving circuit portion has even more excellent transmitting and receiving properties and an even smaller size.

The present invention [3] includes the wired circuit board described in [1] or [2] above, wherein a lower limit of the first aspect ratio is 0.33, and an upper limit of the second aspect ratio is 0.25.

In the wired circuit board, the lower limit of the first aspect ratio is 0.33. Thus, the transmitting and receiving circuit portion has even more excellent transmitting and receiving properties and an even smaller size. Meanwhile, in the wired circuit board, the upper limit of the second aspect ratio is 0. 25. Thus, more excellent crease performance is achieved.

EFFECTS OF THE INVENTION

In the wired circuit board, the component mounting circuit portion has excellent crease performance. Meanwhile, the transmitting and receiving circuit portion has excellent transmitting and receiving properties and a small size.

BRIEF DESCRIPTION OF THE DRAWINGS

[FIG. 1] FIG. 1A and FIG. 1B illustrate a first embodiment of the wired circuit board of the present invention. FIG. 1A is a plan view thereof. FIG. 1B is a cross-sectional view taken along line X-X of FIG. 1A.
[FIG. 2] FIG. 2A to FIG. 2D illustrate the steps of producing the wired circuit board depicted in FIG. 1B. FIG. 2A illustrates a step of preparing a base insulating layer. FIG. 2B illustrates a step of forming a first conductive layer. FIG. 2C illustrates a step of forming a second conductive layer. FIG. 2D illustrates a step of forming a cover insulating layer.
[FIG. 3] FIG. 3A and FIG. 3B illustrate a variation of the first embodiment. FIG. 3A is a plan view thereof. FIG. 3B is a cross-sectional view taken along line X-X of FIG. 1A.
[FIG. 4] FIG. 4A to FIG. 4C illustrate the second embodiment of the wired circuit board of the present invention. FIG. 4A is a plan view thereof. FIG. 4B is a plan view of the second circuit. FIG. 4C is a cross-sectional view taken along line X-X of FIG. 4A and FIG. 4B.

[FIG. 5] FIG. 5A to FIG. 5C illustrate a variation of the second embodiment. FIG. 5A is a plan view thereof. FIG. 5B is a plan view of the second circuit. FIG. 5C is a cross-sectional view taken along line X-X of FIG. 5A and FIG. 5B.

[FIG. 6] FIG. 6A to FIG. 6C illustrate the third embodiment of the wired circuit board of the present invention. FIG. 6A is a plan view thereof. FIG. 6B is a plan view of a second circuit. FIG. 6C is a cross-sectional view taken along line X-X of FIG. 6A and FIG. 6B.

[FIG. 7] FIG. 7A to FIG. 7C illustrate a variation of the third embodiment. FIG. 7A is a plan view thereof. FIG. 7B is a plan view of a second circuit. FIG. 7C is a cross-sectional view taken along line X-X of FIG. 7A and FIG. 7B.

[FIG. 8] FIG. 8A to FIG. 8C illustrate another variation of the third embodiment. FIG. 8A is a plan view thereof. FIG. 8B is a plan view of a second circuit. FIG. 8C is a cross-sectional view taken along line X-X of FIG. 8A and FIG. 8B.

DESCRIPTION OF THE EMBODIMENTS

[First embodiment]

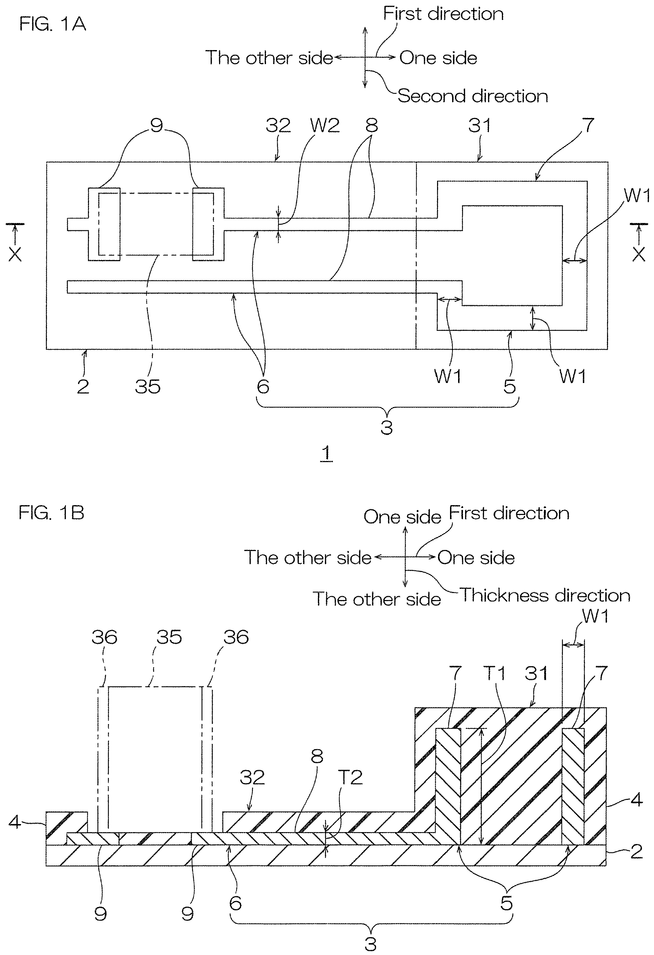

The first embodiment of the wired circuit board of the present invention will be described with reference to FIG. 1A and FIG. 1B. To clarity the position and shape of a circuit 3 (described below), a cover insulating layer 4 (described below) is omitted in FIG. 1A.

A wired circuit board 1 of the first embodiment has a sheet shape. The wired circuit board 1 extends in a first direction. The first direction is orthogonal to a thickness direction. The wired circuit board 1 includes a transmitting and receiving portion 31 and a component mounting portion 32.

The transmitting and receiving portion 31 is a region that receives an outside signal and/or transmits a signal to the outside. The transmitting and receiving portion 31 is disposed at a one-side end in the first direction of the wired circuit board 1.

The component mounting portion 32 is a region on which a mounted component 35 (phantom line) described below is mounted. The component mounting portion 32 is disposed at the other side in the first direction of the transmitting and receiving portion 31. The component mounting portion 32 continues to the transmitting and receiving portion 31.

The wired circuit board 1 includes a base insulating layer 2, the circuit 3, and the cover insulating layer 4. Preferably, the wired circuit board 1 includes only the base insulating layer 2, circuit 3, and cover insulating layer 4.

The base insulating layer 2 is an example of the insulating layer. The base insulating layer 2 forms the other-side surface in the thickness direction of the wired circuit board 1. The base insulating layer 2 has the same shape as that of the wired circuit board 1 in the plan view. The base insulating layer 2 extends over the transmitting and receiving portion 31 and the component mounting portion 32. The thickness of the base insulating layer 2 is not especially limited. The lower limit of the thickness of the base insulating layer 2 is, for example, 1 $\mu$m, preferably, 3 $\mu$m. The upper limit of the thickness of the base insulating layer 2 is, for example, 200 $\mu$m, preferably, 150 $\mu$m. The material of the base insulating layer 2 is, for example, resin. Examples of the resin include polyimide.

The circuit 3 is disposed at one side in the thickness direction of the base insulating layer 2. Specifically, the circuit 3 is in contact with a one-side surface in the thickness direction of the base insulating layer 2. The circuit 3 extends over the transmitting and receiving portion 31 and the component mounting portion 32. The circuit 3 includes a transmitting and receiving circuit 5 and a component mounting circuit 6.

The transmitting and receiving circuit 5 receives an outside signal and/or transmits a signal to the outside. The signal includes, for example, electricity and electrical waves. Specifically, examples of the transmitting and receiving circuit 5 include antennas and coils. The transmitting and receiving circuit 5 is included in the transmitting and receiving portion 31. The transmitting and receiving circuit 5 includes a first wire 7. Preferably, the transmitting and receiving circuit 5 includes only the first wire 7.

In the plan view, the first wire 7 has an approximately C shape opening toward the other side in the first direction. Specifically, the first wire 7 has a loop shape with a cut part. Thus, the transmitting and receiving circuit 5 is sometimes called as a loop antenna.

As long as satisfying a first aspect ratio R1 described below, a width W1 of the first wire 7 is not especially limited. The width W1 of the first wire 7 is a length in a direction orthogonal to a direction in which the first wire 7 extends and the thickness direction. The lower limit of the width W1 of the first wire 7 is, for example, 10 $\mu$m, preferably 20 $\mu$m. The upper limit of the width W1 of the first wire 7 is, for example, 500 $\mu$m, preferably 300 $\mu$m.

As long as satisfying the first aspect ratio R1 described below, a thickness T1 of the first wire 7 is not especially limited. The thickness T1 of the first wire 7 is a distance between the one-side surface in the thickness direction of the base insulating layer 2 and a one-side surface in the thickness direction of the first wire 7. The thickness T1 of the first wire 7 is the same as a thickness of the transmitting and receiving circuit 5. The lower limit of the thickness T1 of the first wire 7 is, for example, 5 $\mu$m, preferably 8 $\mu$m, more preferably 10 $\mu$m. The upper limit of the thickness T1 of the first wire 7 is, for example, 50 $\mu$m.

The first aspect ratio R1 of the first wire 7 is a ratio (T1/W1) of the thickness T1 of the first wire 7 to the width W1 of the first wire 7. As long as being higher than a second aspect ratio R2 of a second wire 8 described below, the first aspect ratio R1 of the first wire 7 is not especially limited. Specifically, the lower limit of the first aspect ratio R1 of the first wire 7 is, for example, 0.33, preferably 0.5, more preferably 1, even more preferably 2. When the first aspect ratio R1 of the first wire 7 is the above-described lower limit or more, the transmitting and receiving circuit 5 has excellent transmitting and receiving properties and a small size. The upper limit of the first aspect ratio R1 of the first wire 7 is not especially limited. The upper limit of the first aspect ratio R1 of the first wire 7 is, for example, 1000 and, for example, 500.

The component mounting circuit 6 inputs the signal transmitted from the transmitting and receiving circuit 5 into the mounted component 35 (phantom line), and/or, transmits the signal output from the mounted component 35 (phantom line) to the transmitting and receiving circuit 5. The component mounting circuit 6 is included in the component mounting portion 32. Specifically, the component mounting circuit 6 includes the second wires 8 and terminals 9.

The second wires 8 extend in the first direction. A plurality (two) of the second wires 8 is provided in a second direction, separating from each other with a space therebetween. The second direction is orthogonal to the first direction and the thickness direction. The second wires 8 continue to two ends of the first wire 7, respectively.

As long as satisfying the second aspect ratio R2 described below, a width W2 of each of the second wires 8 is not especially limited. The lower limit of the width W2 of the second wire 8 is, for example, 20 $\mu$m, preferably 50 $\mu$m. The upper limit of the width W2 of the second wire 8 is, for example, 1000 $\mu$m, preferably 500 $\mu$m.

As long as satisfying the second aspect ratio R2 described below, a thickness T2 of each of the second wires 8 is not especially limited. The thickness T2 of the second wire 8 is a distance of the one-side surface in the thickness direction of the base insulating layer 2 and a one-side surface in the thickness direction of the second wire 8. The lower limit of the thickness T2 of the second wire 8 is, for example, 3 $\mu$m, preferably 5 $\mu$m. The upper limit of the thickness T2 of the second wire 8 is, for example, 15 $\mu$m, preferably 10 $\mu$m.

As long as being lower than the above-described first aspect ratio R1, the second aspect ratio R2 is not especially limited. The second aspect ratio R2 of each of the second wires 8 is a ratio (T2/W2) of the thickness T2 of the second wire 8 to the width W2 of the second wire 8. The upper limit of the second aspect ratio R2 of the second wire 8 is, for example, 0.25, preferably 0.20, more preferably 0.10. When the second aspect ratio R2 of the second wire 8 is less than or equal to the above-described upper limit, the component mounting portion 32 has excellent crease performance. The lower limit of the second aspect ratio R2 of the second wire 8 is not especially limited. The lower limit of the second aspect ratio R2 of the second wire 8 is, for example, 0.01, preferably 0.05.

Further, the second aspect ratio R2 of the second wire 8 is lower than the first aspect ratio R1 of the first wire 7. In short, the R1 and R2 satisfy the following expression (1).

$$ R2 < R1 \quad (1) $$

On the other hand, when the second aspect ratio R2 of the second wire 8 is more than or equal to the first aspect ratio R1 of the first wire 7, the component mounting portion 32 has low crease performance, and the transmitting and receiving portion 31 cannot have a small size. The "small size" means that the transmitting and receiving portion 31 can be downsized in the plan view.

The upper limit of a ratio R3 (= R2/R1) of the second aspect ratio R2 to the first aspect ratio R1 is, for example, 0.9, preferably 0. 8, more preferably 0.75, even more preferably 0.5. When the above-described ratio R3 is lower than or equal to the above-described upper limit, the component mounting portion 32 has more excellent crease performance, and the transmitting and receiving portion 31 can more surely have a small size. The lower limit of the ratio R3 of the second aspect ratio R2 to the first aspect ratio R1 is not especially limited. The lower limit of the above-described ratio R3 is, for example, 0.03.

The upper limit of a difference D (= R1 - R2) obtained by subtracting the second aspect ratio R2 from the first aspect ratio R1 is, for example, 0.5, preferably 0.3, more preferably 0.25, even more preferably 0.2. When the above-described difference D is lower than or equal to the above-described upper limit, the component mounting portion 32 has more excellent crease performance, and the component mounting portion 32 can more surely have a small size. The lower limit of the difference D is not especially limited. The lower limit of the difference D is, for example, 0.08.

The terminals 9 are disposed on the one-side surface in the thickness direction of the base insulating layer 2 in the transmitting and receiving portion 31. The terminals 9 continue to one of the plurality of the second wires 8. The terminals 9 intervene in the middle of one of the second wires 8. The two terminals 9 are disposed in the first direction, separating from each other with a space therebetween. Each of the two terminals 9 has an approximately rectangular land pattern shape. The terminals 9 are exposed at the one side in the thickness direction. The size and area of each of the terminals 9 is not limited. The terminal 9 has, for example, the same thickness as that of the thickness T2 of the second wire 8.

Examples of the material of the circuit 3 include metals. Examples of the metals include copper, silver, gold, and solder. As the metal, preferably, copper is used.

As illustrated in FIG. 1B, the cover insulating layer 4 is disposed at the one side in the thickness direction of the base insulating layer 2. The cover insulating layer 4 extends over the transmitting and receiving portion 31 and the component mounting portion 32. The cover insulating layer 4 covers the first wire 7 and the second wires 8. The cover insulating layer 4 exposes the terminals 9. Examples of the material of the cover insulating layer 4 include resins. As the resin, for example, polyimide is used. The thickness of the cover insulating layer 4 is not especially limited.

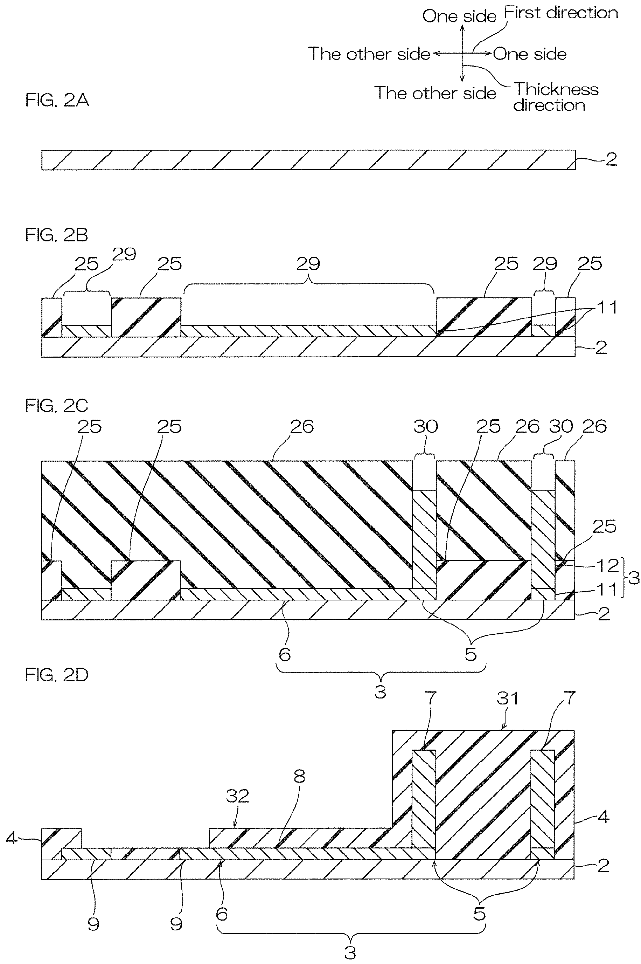

An exemplary method of producing the wired circuit board 1 will be described. FIG. 2A to FIG. 2D will be referred to.

As illustrated in FIG. 2A, in the method, the base insulating layer 2 is prepared.

As illustrated in FIG. 2B and FIG. 2C, in the method, the circuit 3 is subsequently formed on the one-side surface in the thickness direction of the base insulating layer 2. For example, the circuit 3 is formed by an additive method. Specifically, as illustrated in FIG. 2B, the first conductive layer 11 is formed first. Subsequently, as illustrated in FIG. 2C, the second conductive layer 12 is formed.

As illustrated in FIG. 2B, in the plan view, the first conductive layer 11 has the same shape as those of the above-described transmitting and receiving circuit 5 and component mounting circuit 6. Meanwhile, as illustrated in FIG. 2C, the second conductive layer 12 has the same shape as that of the above-described transmitting and receiving circuit 5. In other words, the transmitting and receiving circuit 5 includes the first conductive layer 11 and the second conductive layer 12 toward the one side in the thickness direction. On the other hand, the component mounting circuit 6 does not include the second conductive layer 12 and includes only the first conductive layer 11.

Before the first conductive layer 11 is formed, if necessary, a metal underlying layer (not illustrated) is disposed on the one-side surface in the thickness direction of the base insulating layer 2.

Subsequently, a first plated resist 25 is disposed on the one-side surface in the thickness direction of the metal underlying layer (or the base insulating layer 2). The first plated resist 25 has a reverse pattern to those of the transmitting and receiving circuit 5 and component mounting circuit 6. In other words, the first plated resist 25 has a first plated opening portion 29 corresponding to the transmitting and receiving circuit 5 and component mounting circuit 6.

Thereafter, by plating, the first conductive layer 11 is formed in the first plated opening portion 29. Examples of the plating include electrolytic plating and non-electrolytic plating. As the plating, preferably, electrolytic plating is used.

Thereafter, a second plated resist 26 is disposed on the first conductive layer 11 on the component mounting circuit 6. The second plated resist 26 include a second plated opening portion 30 corresponding to the transmitting and receiving circuit 5.

Thereafter, by plating, the second conductive layer 12 is formed in the second plated opening portion 30. Examples of the plating include electrolytic plating and non-electrolytic plating. As the plating, preferably, electrolytic plating is used.

In this manner, the circuit 3 including the first conductive layer 11 and the second conductive layer 12 is formed.

Thereafter, the first plated resist 25 and the second plated resist 26 are removed. Subsequently, the metal underlying layer corresponding to the first plated resist 25 is removed.

Thereafter, as illustrated in FIG. 2D, the cover insulating layer 4 is formed. For example, varnish including photosensitive resin is applied to the base insulating layer 2 and the circuit 3, thereby forming a photosensitive application film. Thereafter, by a photolithographic method, the cover insulating layer 4 is formed from the photosensitive application film.

In this manner, the wired circuit board 1 including the base insulating layer 2, the circuit 3, and the cover insulating layer 4.

As illustrated in FIG. 1A and FIG. 1B, thereafter, the terminals 9 of the circuit 3 are electrically connected to the mounted component 35 (phantom line). The mounted component 35 is mounted on the component mounting portion 32. The mounted component 35 includes two electrodes 36 (phantom line). The two electrodes 36 are in contact with the two terminals 9, respectively.

Although not illustrated, while the wired circuit board 1 is used, the component mounting portion 32 can be bent.

[Operations and effects of the first embodiment]

Further, in the wired circuit board 1, the second wires 8 each have a second aspect ratio R2 lower than the first aspect ratio R1 of the first wire 7. Thus, the component mounting portion 32 has excellent crease performance. In other words, when the component mounting portion 32 is bent while the wired circuit board 1 is used, the damage to the component mounting portion 32 is suppressed.

Meanwhile, the transmitting and receiving portion 31 has excellent transmitting and receiving properties and a small size.

Furthermore, in the wired circuit board 1, when the upper limit of the ratio 3 (=R2/R1) of the second aspect ratio R2 to the first aspect ratio R1 is 0.9, the component mounting portion 32 has more excellent crease performance, and the transmitting and receiving portion 31 can surely have a small size.

Furthermore, in the wired circuit board 1, when the lower limit of the first aspect ratio R1 of the first wire 7 is 0.33, the transmitting and receiving circuit 5 has excellent transmitting and receiving properties and a small size.

Furthermore, in the wired circuit board 1, when the upper limit of the second aspect ratio R2 of the second wire 8 is 0.25, the component mounting portion 32 has excellent crease performance.

[Variation of the first embodiment]

In a variation, the same members and steps as in the first embodiment will be given the same numerical references and the detailed description thereof will be omitted. Further, the variation has the same operations and effects as those of the first embodiment unless especially described otherwise. Furthermore, the first embodiment and the variation can appropriately be combined.

Although not illustrated, alternatively, after the first conductive layer 11 having the same shape as that of the transmitting and receiving circuit 5 is first formed, the second conductive layer 12 having the same shape as that of the component mounting circuit 6 can be formed. In the variation, the transmitting and receiving circuit 5 is, for example, a single layer.

Although not illustrated, alternatively, the circuit 3 can be formed by a subtractive method.

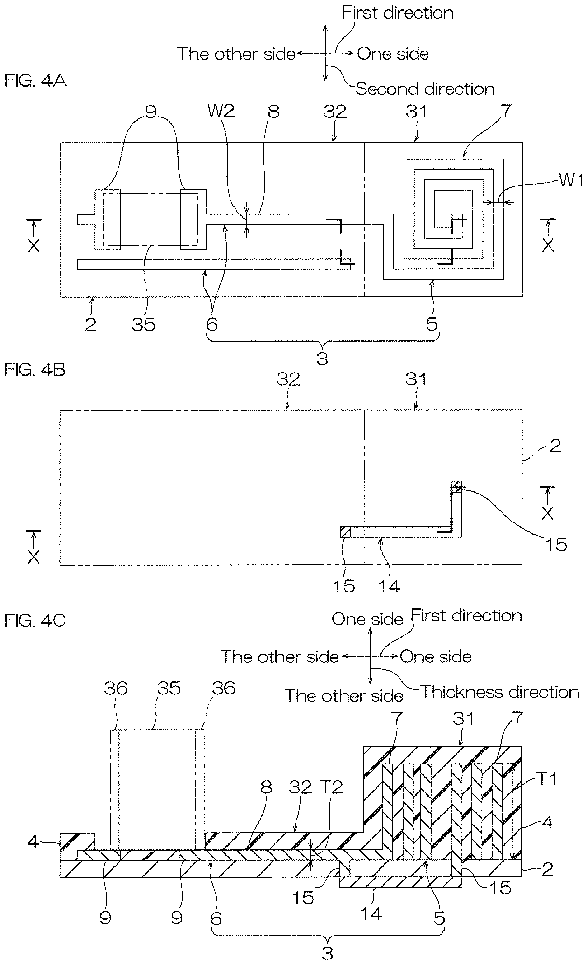

The shape of the transmitting and receiving circuit 5 is not especially limited. The transmitting and receiving circuit 5 may have a spiral shape. The spiral shape is shown in FIG. 4A, FIG. 6A, and FIG. 8A.

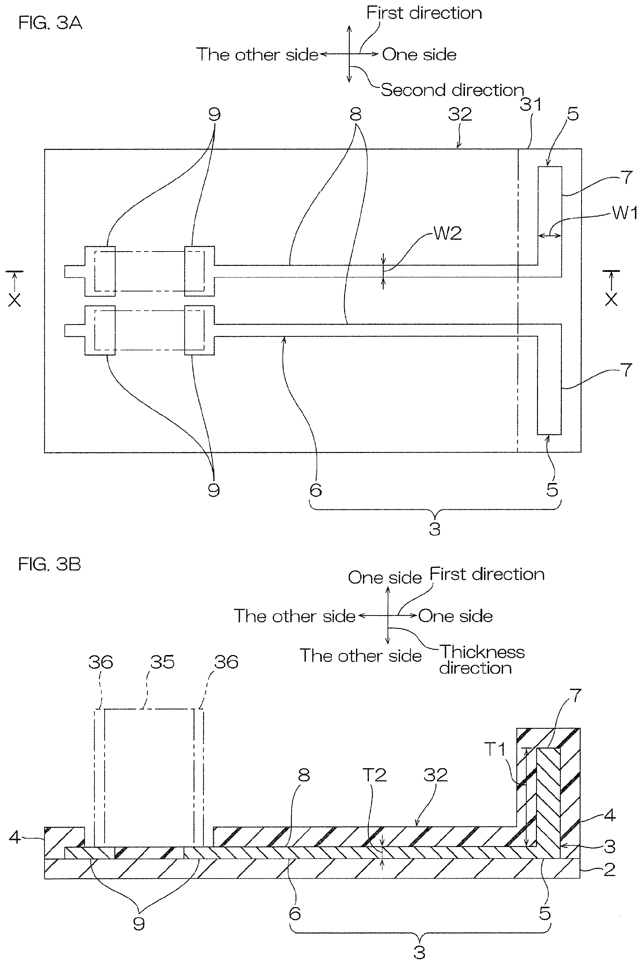

As illustrated in FIG. 3A and FIG. 3B, in the variation, the first wire 7 has an approximately straight line shape in the plan view. The transmitting and receiving circuit 5 including the above-described first wire 7 can be called as a dipole antenna. The first wire 7 extends along the second direction. Specifically, the first wire 7 extends from an end in the first direction of the second wire 8 toward the outside in the second direction. In this manner, the first wire 7 and the second wire 8 form an approximately L shape in the plan view.

Each of the two second wires 8 in the component mounting circuit 6 is provided with the two terminals 9. For each one of the second wires 8, the two terminals 9 are provided.

[Second embodiment]

In the second embodiment, the same members and steps as in the first embodiment will be given the same numerical references and the detailed description thereof will be omitted. Further, the second embodiment has the same operations and effects as those of the first embodiment unless especially described otherwise. Furthermore, the first embodiment and the second embodiment can appropriately be combined.

The second embodiment of the wired circuit board of the present invention will be described with reference to FIG. 4A to FIG. 4C. In FIG. 4B, to clarify the positions and shapes of a second circuit 14 (described below) and a connecting portion 15 (described below), a base insulating layer 2 is illustrated with a phantom line, and a circuit 3 is omitted.

A wired circuit board 1 further includes the second circuit 14 and the connecting portion 15.

The second circuit 14 is disposed on the other side in the thickness direction of a base insulating layer 2. The second circuit 14 is in contact with the other-side surface in the thickness direction of the base insulating layer 2. The second circuit 14 has, for example, an approximately L shape in the plan view. Examples of the material of the second circuit 14 include metals. Examples of the metals include stainless steels, copper alloys, irons, and, coppers. As the metal, preferably, a stainless steel is used. The size and thickness of the second circuit 14 is not especially limited.

The connecting portion 15 electrically connects the circuit 3 and the second circuit 14. In the plan view, the connecting portion 15 is disposed on a one-side surface in the thickness direction of each of two ends of the second circuit 14. One of the two connecting portions 15 is integrated with an end in a first direction of the second wire 8. The second wire 8 is the one of the two second wires 8 in which the terminals 9 do not intervene. The other one of the two connecting portions 15 is integrated with an end of the first wire 7. The material of the connecting portion 15 is, for example, the same metal as the circuit 3. The circuit 3 has the same thickness as that of the base insulating layer 2.

In the second embodiment, the first wire 7 has a spiral shape. An internal end of the first wire 7 continues to the above-described connecting portion 15. An external end of the first wire 7 continues to the second wire 8 in which the terminals 9 intervene.

In the wired circuit board 1 of the second embodiment, an electrical path is formed from the second wire 8 in which the terminals 9 intervene, through the first wire 7 and the second circuit 14, to the second wire 8 in which the terminals 9 do not intervene.

[Variation of the second embodiment]

In a variation, the same members and steps as in the second embodiment will be given the same numerical references and the detailed description thereof will be omitted. Further, the variation has the same operations and effects as those of the second embodiment unless especially described otherwise. Furthermore, the second embodiment and the variation can appropriately be combined.

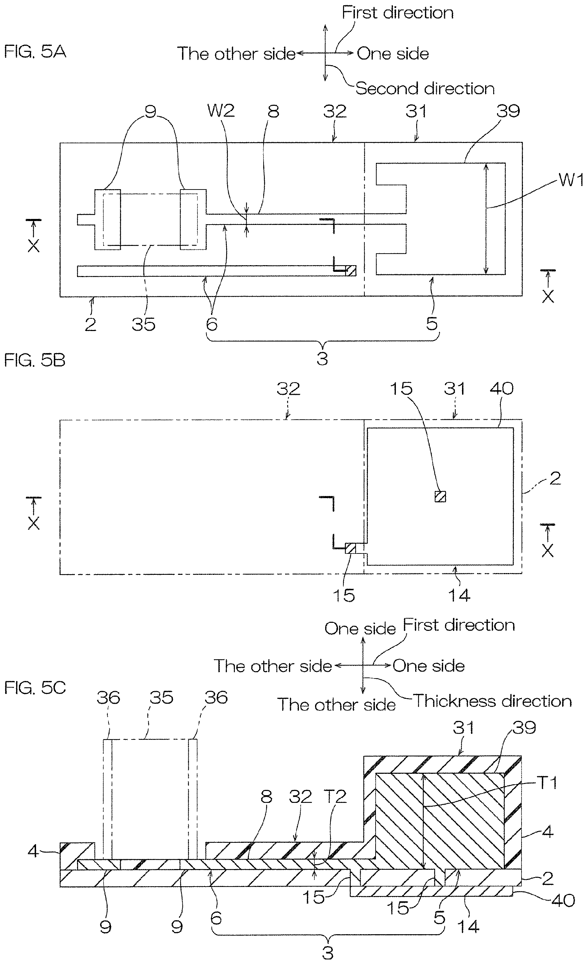

The variation of the second embodiment will be described with reference to FIG. 5A to FIG. 5C. In FIG. 5B, to clarify the positions and shapes of a second circuit 14 (described below) and a connecting portion 15 (described below), a base insulating layer 2 is illustrated with a phantom line, and a circuit 3 is omitted.

As illustrated in FIG. 5A, a transmitting and receiving circuit 5 includes a first conductive board 39. The first conductive board 39 has an approximately rectangular shape extending in a first direction and a second direction. The first conductive board 39 has a flat plate shape. The transmitting and receiving circuit 5 can be called as a microstrip antenna.

The second circuit 14 includes a second conductive board 40. The second conductive board 40 has a rectangular shape extending in the first direction and the second direction. The second conductive board 40 has a flat plate shape. At each of an end and center part of the second conductive board 40, the connecting portion 15 is provided.

[Third embodiment]

In the third embodiment, the same members and steps as in the first embodiment and the second embodiment will be given the same numerical references and the detailed description thereof will be omitted. Further, the third embodiment has the same operations and effects as those of the first embodiment and the second embodiment unless especially described otherwise. Furthermore, the first to third embodiments can appropriately be combined.

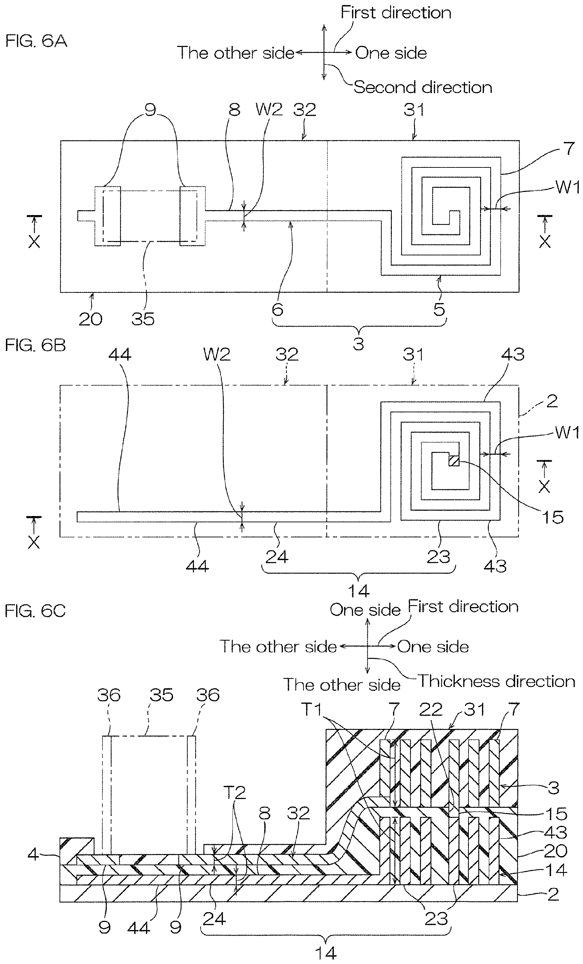

The third embodiment of the wired circuit board of the present invention will be described with reference to FIG. 6A to FIG. 6C. In FIG. 6B, to clarify the positions and shapes of a second circuit 14 (described below) and a connecting portion 15 (described below), a base insulating layer 2 is illustrated with a phantom line, and a circuit 3 is omitted.

A wired circuit board 1 further includes a second base insulating layer 20. Specifically, the wired circuit board 1 includes the base insulating layer 2, the second circuit 14, the connecting portion 15, the second base insulating layer 20, the circuit 3, and a cover insulating layer 4.

In the wired circuit board 1, the second circuit 14 is disposed on a one side in the thickness direction of the base insulating layer 2. The second circuit 14 includes a second transmitting and receiving circuit 23 and a linear circuit 24.

The second transmitting and receiving circuit 23 includes a third wire 43. The third wire 43 has an approximately spiral shape in the plan view. The third wire 43 has the same first aspect ratio R1 as that of the first wire 7 of the first embodiment.

The linear circuit 24 includes a fourth wire 44 extending in the first direction. The fourth wire 44 continues to an external end of the second transmitting and receiving circuit 23. The fourth wire 44 has the same second aspect ratio R2 as that of the second wire 8 of the first embodiment.

The connecting portion 15 is disposed on a one-side surface in the thickness direction at an internal end of the second transmitting and receiving circuit 23.

The second base insulating layer 20 is also an example of the insulating layer. The second base insulating layer 20 is disposed on a one-side surface in the thickness direction of the base insulating layer 2. The second base insulating layer 20 covers the second circuit 14. The second base insulating layer 20 has a base penetrating hole 22. The base penetrating hole 22 penetrates the second base insulating layer 20 in the thickness direction. The base penetrating hole 22 is filled with the connecting portion 15.

The circuit 3 is disposed on a one-side surface in the thickness direction of the second base insulating layer 20. The circuit 3 includes a transmitting and receiving circuit 5 and a component mounting circuit 6. The transmitting and receiving circuit 5 has an approximately spiral shape in the plan view. An internal end of the transmitting and receiving circuit 5 is integrated with the connecting portion 15. The component mounting circuit 6 includes one second wire 8 and two terminals 9.

The cover insulating layer 4 is disposed on the one side in the thickness direction of the second base insulating layer 20. The cover insulating layer 4 covers the circuit 3.

In the wired circuit board 1 of the third embodiment, the component mounting circuit 6, the transmitting and receiving circuit 5, and the second circuit 14 are electrically connected. Specifically, an electrical path is formed from the component mounting circuit 6 though the transmitting and receiving circuit 5 and second transmitting and receiving circuit 23 to a linear circuit 24.

[Variations of the third embodiment]

In the following variations, the same members and steps as in the third embodiment will be given the same numerical references and the detailed description thereof will be omitted. Further, each of the variations has the same operations and effects as those of the third embodiment unless especially described otherwise. Furthermore, the third embodiment and the variations can appropriately be combined.

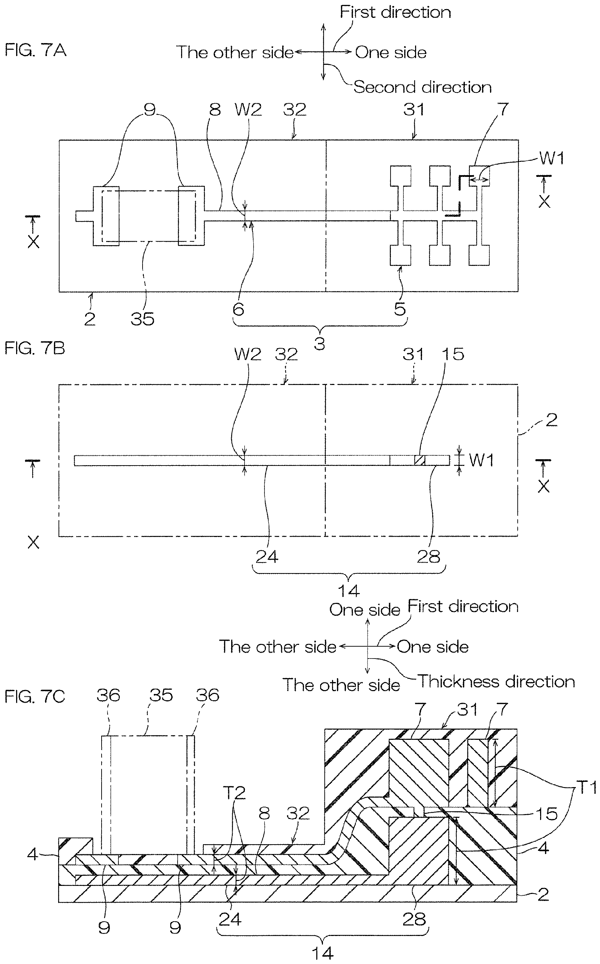

A variation of the third embodiment will be described with reference to FIG. 7A to FIG. 7C. In FIG. 7B, to clarify the positions and shapes of a second circuit 14 (described below) and a connecting portion 15 (described below), a base insulating layer 2 is illustrated with a phantom line, and a circuit 3 is omitted.

As illustrated in FIG. 7A to FIG. 7C, in the variation, a first wire 7 is disposed and formed into a patch shape. Thus, the transmitting and receiving circuit 5 can be called as a patch array antenna.

The second circuit 14 extends in a first direction. The second circuit 14 includes a second striation circuit 28 and the linear circuit 24. The second striation circuit 28 has the same first aspect ratio R1 as that of the second transmitting and receiving circuit 23. The linear circuit 24 has the same second aspect ratio R2 as that of the linear circuit 24 of the third embodiment.

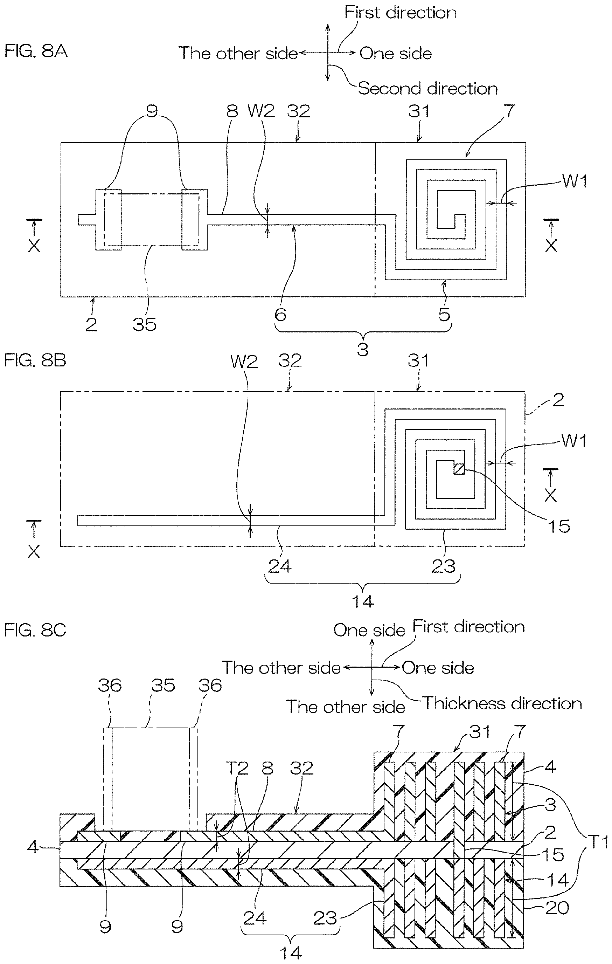

As illustrated in FIG. 8A to FIG. 8C, in another variation, a second base insulating layer 20 is disposed at the other side in the thickness direction of a base insulating layer 2. The second base insulating layer 20 is disposed on the other-side surface in the thickness direction of the base insulating layer 2. The second base insulating layer 20 covers a second circuit 14. The second circuit 14 is disposed at the other-side in the thickness direction of the base insulating layer 2.

While the illustrative embodiments of the present invention are provided in the above description, such is for illustrative purpose only and it is not to be construed as limiting in any manner. Modification and variation of the present invention that will be obvious to those skilled in the art is to be covered by the following claims.

Description of Reference Numerals

| 1 | wired circuit board |
| 2 | base insulating layer |
| 3 | circuit |
| 5 | transmitting and receiving circuit |
| 6 | component mounting circuit |
| 7 | first wire |
| 8 | second wire |
| 14 | second circuit |
| 20 | second base insulating layer |

**Claims**

1. A wired circuit board comprising:

   an insulating layer, and
   a circuit disposed on a one-side surface in a thickness direction of the insulating layer, wherein the circuit includes
   a transmitting and receiving circuit, and
   a component mounting circuit electrically connected to the transmitting and receiving circuit,

   the transmitting and receiving circuit includes a first wire,
   the first wire has a first aspect ratio that is a ratio of a thickness to a width,
   the component mounting circuit includes a second wire electrically connected to the first wire, and
   the second wire has a second aspect ratio lower than the first aspect ratio.

2. The wired circuit board according to Claim 1, wherein an upper limit of a ratio of the second aspect ratio to the first aspect ratio is 0.9.

3. The wired circuit board according to Claim 1 or 2, wherein a lower limit of the first aspect ratio is 0.33, and an upper limit of the second aspect ratio is 0.25.

FIG. 1A

First direction

The other side ← → One side

Second direction

1

FIG. 1B

One side   First direction

The other side ← → One side

The other side   Thickness direction

W1

3

One side ⌐First direction

The other side ← → One side

The other side ⌐Thickness direction

FIG. 2A

2

FIG. 2B

25  29  25              29              25  29  25

11

2

FIG. 2C

25      25          26          30      25 26 30 26

25

12 ⎱ 3
11 ⎰

2

6                      5

3

FIG. 2D

7      31      7

32      8

4

4

9    9    6              5

3

FIG. 3A

FIG. 3B

FIG. 4A

First direction

The other side ← → One side

Second direction

FIG. 4B

FIG. 4C

One side  First direction

The other side ← → One side

The other side  Thickness direction

FIG. 5A

First direction

The other side ← → One side

Second direction

9  W2  8  32  31  39

W1

X

2  35  6  5

3

FIG. 5B

32  15  31  40

2

X

X

15  14

One side  First direction

The other side ← → One side

The other side  Thickness direction

FIG. 5C

36  35  36

31  39

T1

8  32  T2

4

4  2

15  40

9  9  6  15  5  14

3

FIG. 6A

First direction
The other side ←→ One side
Second direction

FIG. 6B

FIG. 6C

One side / First direction
The other side ←→ One side
The other side / Thickness direction

FIG. 7A

First direction

The other side ←→ One side

Second direction

9  8 W2 32  31  7

W1

X

X

2  35  6  5

3

FIG. 7B

W2 32  3  31 15

2

X

W1

X

24  28

14

One side First direction

The other side ←→ One side

The other side Thickness direction

FIG. 7C  36  35  36

7  31  7

T1

T2

8  32  15

4  4

2

9  9  24  28

14

FIG. 8A

First direction

The other side ←→ One side

Second direction

9  8 W2 32  31  7

W1

X

X

2  35  6  5

3

FIG. 8B

W2  32  31

2

W1

X

15

X

24  23

14

FIG. 8C

One side  First direction

The other side ←→ One side

The other side  Thickness direction

36  35  36

7  31  7

4

3

T2 8 32

2

15

14

20

4

9  9  24  23

14

T1

Europäisches
Patentamt
European
Patent Office
Office européen
des brevets

# EUROPEAN SEARCH REPORT

Application Number

EP 21 19 2548

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 945 959 A (TANIDOKORO HIROAKI [JP] ET AL) 31 August 1999 (1999-08-31) * column 18 - column 26; figures 12-18 * | 1-3 | INV. H01Q1/36 ADD. |
| X | ZHAI GUOHUA ET AL: "Uniplanar Millimeter-Wave Log-Periodic Dipole Array Antenna Fed by Coplanar Waveguide", INTERNATIONAL JOURNAL OF ANTENNAS AND PROPAGATION, vol. 2013, 27 October 2013 (2013-10-27), pages 1-5, XP055878474, ISSN: 1687-5869, DOI: 10.1155/2013/430618 | 1,2 | H01Q1/38 H01Q13/20 H01Q7/00 H01Q9/04 H01Q9/27 H01Q9/28 |
| A | * the whole document * | 3 | |
| X | MING-REN HSU ET AL: "Ceramic chip antenna for WWAN operation", MICROWAVE CONFERENCE, 2008. APMC 2008. ASIA-PACIFIC, IEEE, PISCATAWAY, NJ, USA, 16 December 2008 (2008-12-16), pages 1-4, XP031458253, DOI: 10.1109/APMC.2008.4958578 ISBN: 978-1-4244-2641-6 * the whole document * | 1-3 | TECHNICAL FIELDS SEARCHED (IPC) H01Q |
| A | Ditron M.: "MSC-Ditron s MSC-Ditron FR-4 copper clad Laminate EP-84 Available Thicknesses and Tolerances: Available Copper Thicknesses: Thickness [mm]", , 11 June 2006 (2006-06-11), XP055879500, Retrieved from the Internet: URL:https://www.pcb-pool.com/download/spez ifikation/eng_EP_84_FR4__copper_clad____MS C_Ditron_TDS.pdf [retrieved on 2022-01-16] * the whole document * | 1-3 | |

The present search report has been drawn up for all claims

| Place of search | Date of completion of the search | Examiner |
|---|---|---|
| The Hague | 17 January 2022 | Keyrouz, Shady |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 21 19 2548

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2022

| Patent document cited in search report | | Publication date | Patent family member(s) | | Publication date |
|---|---|---|---|---|---|
| US 5945959 | A | 31-08-1999 | DE | 69726523 T2 | 30-09-2004 |
| | | | EP | 0829917 A1 | 18-03-1998 |
| | | | KR | 19980024558 A | 06-07-1998 |
| | | | US | 5945959 A | 31-08-1999 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016147993 A